Europäisches Patentamt

European Patent Office

Office européen des brevets

(11) Veröffentlichungsnummer: **0 047 001**
**B1**

(12) **EUROPÄISCHE PATENTSCHRIFT**

(45) Veröffentlichungstag der Patentschrift: 07.05.86

(51) Int. Cl.⁴: **G 11 C 11/40**

(21) Anmeldenummer: **81106742.0**

(22) Anmeldetag: **28.08.81**

(54) Leseverstärker für einen Bipolar-Speicherbaustein.

(30) Priorität: **03.09.80 DE 3033174**

(43) Veröffentlichungstag der Anmeldung:
**10.03.82 Patentblatt 82/10**

(45) Bekanntmachung des Hinweises auf die
Patenterteilung:
**07.05.86 Patentblatt 86/19**

(84) Benannte Vertragsstaaten:
**FR GB NL**

(56) Entgegenhaltungen:
**DE-B-2 739 663**
**US-A-3 729 721**
**US-A-3 760 194**

**IEEE INT.-SOLID STATE CIRCUITS CONF.,
Februar 1980, Seiten 222,223,276, New York,
USA S.K. WIEDMAN: "A 16Kb static MTL/I2L
memory chip"**

**IEEE JOURNAL OF SOLID-STATE CIRCUITS,
Band SC-13, Nr. 5, Oktober 1978, Seiten
651-656, New York, USA A. HOTTA: "A highspeed low-power 4096 x 1 Bit bipolar RAM"**

(73) Patentinhaber: **Siemens Aktiengesellschaft
Berlin und München Wittelsbacherplatz 2
D-8000 München 2 (DE)**

(72) Erfinder: **Glock, Hans, Dipl.-Ing.
Nr.23
D-8063 Höfa (DE)**

Courier Press, Leamington Spa, England.

# 0 047 001

**Beschreibung**

Die Erfindung bezieht sich auf einen Leseverstärker nach dem Oberbegriff des Patentanspruches 1.

Ein Leseverstärker dieser Art für den Einsatz in schnellen ECL-Speicherbausteinen ist durch die DE—PS—20 46 929 bekannt. Aus Gründen, die noch näher dargelegt werden, ergibt sich insbesonders beim Wechsel zwischen zwei Speicherzellen mit gleicher Information eine im Vergleich zur Signallaufzeit $\tau$ lange Zeit $t_s$ mit stark reduzierter Störsicherheit. Die Zeit $t_s$ fällt zudem in einem Zeitraum, in dem der Adressenwechsel erfolgt und deshalb vielfache Schaltvorgänge im Speicherbaustein stattfinden. Die hierdurch erzeugten Störungen greifen, da der bekannte Leseverstärker keine eigene Störunterdrückung besitzt, auf den Datenausgang durch und können die Lesezugriffszeit auf mehr als den doppelten Wert der sich ohne Störeinwirkung ergebenden Zugriffszeit verlängern.

Durch US—A—3760 194 ist ein zweistufiger Leseverstärker mit Störunterdrückung bekannt. Die erste Stufe besteht aus einem Differenzverstärker aus emittergekoppelten Transistoren mit Konstantstromeinspeisung, dessen Eingänge mit den durch Lesewiderstände abgeschlossenen Bitleitungen verbunden sind. Die Kollektoren der Transistoren sind überkreuz ebenfalls mit den Bitleitungen verbunden, so daß jeweils in den von dem höheren Lesestrom durchflossenen Lesewiderstand ein durch die erste Stufe des Leseverstärkers erzeugter Zusatzstrom eingespeist wird.

Die Zweite Stufe besteht gleichfalls aus einem Differenzverstärker, dessen Eingänge über Emitterfolger mit den Bitleitungen verbunden sind. Die zweite Stufe wertet die unterschiedlichen Spannungsabfälle an den Lesewiderständen aus und bildet daraus ein Daten-Ausgangssignal, Einen Zusatzstrom zur alternativen Einspeisung in einen der Lesewiderstände erzeugt die zweite Stufe nicht.

Der Erfindung liegt die Aufgabe zugrunde, einen zur Verringerung des Schaltungsaufwandes einstufig ausgeführten Leseverstärker so auszubilden, daß er eine Störunterdrückung bewirkt, die im Bedarfsfall an die jeweils vorliegenden Verhältnisse durch Änderung der Übertragungskennlinie anpassungfähig ist. Diese Aufgabe wird durch die im kennzeichnenden Teil des Patentanspruchs 1 aufgeführten Maßnahmen gelöst. Weitere Einzelheiten ergeben sich aus den Unteransprüchen, sowie aus der nachstehenden Beschreibung von Ausführungsbeispielen anhand der Zeichnung. Es zeigt darin:

Fig. 1 einen Ausschnitt aus der Speichermatrix mit zwei an gemeinsame Bitleitungen angeschlossenen Speicherzellen,

Fig. 2 ein Diagramm über den Verlauf der Leseströme in den Bitleitungen beim Wechsel der Wortleitungen,

Fig. 3 einen bekannten Leseverstärker,

Fig. 4 einen Leseverstärker gemäß der Erfindung,

Fig. 5 und 6 Leseverstärker-Übertragungskennlinien.

Um das Verständnis der Erfindung zu erleichtern, soll zunächst auf die beim Lesen einer Speicherzelle auftretenden Vorgänge und ihre Auswirkungen auf einen Leseverstärker ohne Störunterdrückung eingegangen werden.

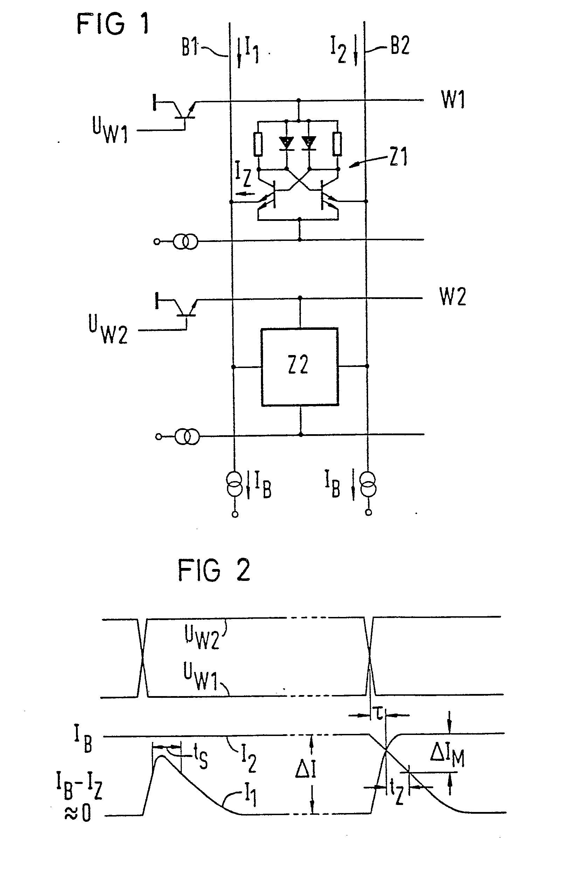

Die Figur 1 zeigt zwei Speicherzellen Z1 und Z2, die in bekannter Weise mit zwei Bitleitungen B1 und B2 verbunden sind und über die Worleitungen W1 oder W2 auswählbar sind. Die Worleitungen sind durch die Auswahlsignale $U_{W1}$ oder $U_{W2}$ aktivierbar. In die Bitleitungen B1 und B2 werden aus Konstantstromquellen die Ströme $I_B$ eingespeist. In der Darstellung nach Figur 1 ist angenommen, daß die Speicherzelle Z1 ausgewählt ist. Aus dem leitenden Transistor dieser Speicherzelle fließt dann ein Strom $I_Z$ zur Bitleitung B1. Ein entsprechender Strom auf der anderen Seite der Speicherzelle fehlt, da der zugehörige Transistor gesperrt ist. Daraus ergibt sich auf der Bitleitung B1 ein Lasestrom $I_1$, der gleich der Differenz $I_B-I_Z$ ist. Durch geeignete Wahl des eingeprägten Stroms $I_B$ wird diese Differenz im allgemeinen wenigstens annähernd zu Null gemacht. Der Lesestrom $I_2$ ist gleich dem eingeprägten Strom $I_B$.

Bie einem Wechsel der angesteuerten Worleitungen, d.h. bei einem Wechsel der ausgewählten Speicherzellen setzen Umladevorgänge ein, die sich auf die Leseströme $I_1$ und $I_2$ auswirken. Die Auswirkungen hängen naturgemäß davon ab, ob die in den ausgetauschten Speicherzellen enthaltenen Informationen gleich oder verschieden sind.

Die Figur 2 zeigt in ihrem oberen Teil den Verlauf der Auswahlsignale $U_{W1}$ und $U_{W2}$. Der jeweils höhere Signalpegel bedeutet die Auswahl der zugeordneten Worleitung W1 oder W2 bzw. der Speicherzelle Z1 oder Z2.

In dem unteren Teil der Figur 2 ist der zeitliche Verlauf der Leseströme $I_1$ und $I_2$ angegeben. Dabei ist vorausgesetzt, daß bei dem ersten Wechsel der Auswahlsignale $U_{W1}$ und $U_{W2}$ die in den Speicherzellen vorliegenden Informationen gleich sind. Wie aus dem Diagramm ersichtlich ist, verändert sich der Lesestrom $I_2=I_B$ nicht merklich, während der Lesestrom $I_1$ weit von seinem quasistationären Wert abweicht und erst langsam auf diesen Wert zurückkehrt. Es läßt sich eine Zeitspanne $t_s$ festlegen, in der sich der Lesestrom $I_1$ dem Lesestrom $I_2$ am stärksten nähert. In dieser Zeit $t_s$ ist die Störsicherheit stark verringert, so daß schon relativ kleine Störimpulse eine Umkehr des Vorzeichens der Lesestromdifferenz $\Delta I$ verursachen können. Wie schon eingangs erwähnt wurde, laufen gerade in dieser Zeit in der integrierten Schaltungsanordnung vielfache Schaltvorgänge ab, die durch den eben erfolgten Adresswechsel verursacht sind.

In dem Diagramm Figur 2 ist für den zweiten Wechsel der ausgewählten Speicherzellen Z1 und Z2 durch erneute Vertauschung der Auswahlsignale $U_{W1}$, $U_{W2}$ unterstellt, daß die beiden Speicherzellen Z1

2

und Z2 verschiedene Informationsinhalte haben. Dementsprechend wechseln auch die Leseströme $I_1$ und $I_2$ ihre Werte. Auffallend ist der langsame Übergang des Lesestroms $I_2$. Dafür ist im wesentlichen die Umladung der Kapazität der Bitleitung B1 über den hochohmigen (z.B. 40 kΩ) Lastwiderstand auf der stromführenden Seite der ausgewählten Speicherzelle (hier wieder Z1) verantwortlich.

Relativ rasch hingegen geht der Übergang des Lasestroms $I_1$ vor sich, so daß die Zeitspanne τ (Signallaufzeit) zwischen dem Wechsel der Auswahlsignale $U_{W1}$ und $U_{W2}$ und dem Zeitpunkt, in dem die Differenz ΔI der Leseströme $I_1$ und $I_2$ Null wird, kurz bleibt.

Est ist klar, daß die Übergangsphase der Leseströme $I_1$ und $I_2$, in der ihre Differenz ΔI klein wird oder verschwindet, wieder sehr anfällig gegen Störimpulse ist, welche die Leseströme überlagern. Es hängt von den Eigenschaften der Leseverstärker ab, inwieweit sich die Störungen im Datenausgangssignal bemerkbar machen.

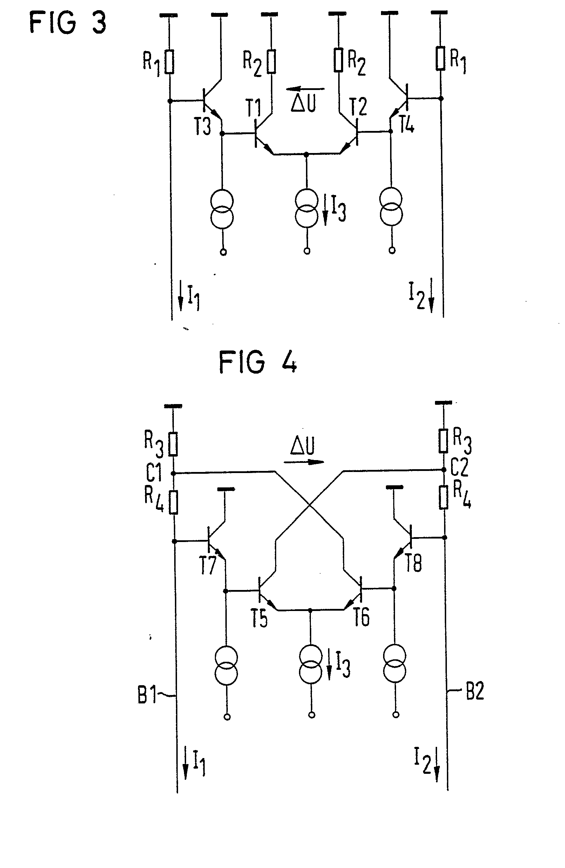

Die Figur 3 zeigt einen häufig verwendeten Leseverstärker. Er enthält einen Differenzverstärker mit den emittergekoppelten Transistoren T1 und T2. Der Differenzverstärker wird mit einem konstanten Strom $I_3$ gespeist. Den Eingängen des Differenzverstärkers sind Emitterfolger mit den Transistoren T3 und T4 vorgeschaltet. Sie werden durch die von den Leseströmen $I_1$ bzw. $I_2$ erzeugten Spannungsabfälle in den Lesewiderständen $R_1$ gesteuert. Die Differenz ΔU zwischen den Kollektoren der Transistoren T1 und T2 bildet das Ausgangssignal. Die Widerstände $R_2$ sind die zugehörigen Kollektorwiderstände.

Der bekannte Leseverstärker nach Figur 3 besitzt eine Übertragungskennlinie, die durch die folgende Beziehung unter Vernachlässigung der sehr kleinen Basisströme der beteiligten Transistoren gegeben ist:

$$\Delta U = (1 - \frac{2}{1+e^{\Delta I \cdot R_1/U_T}}) \, I_3 \cdot R_2$$

wobei $U_T = 26$ mV die sogenannte Temperaturspannung ist.

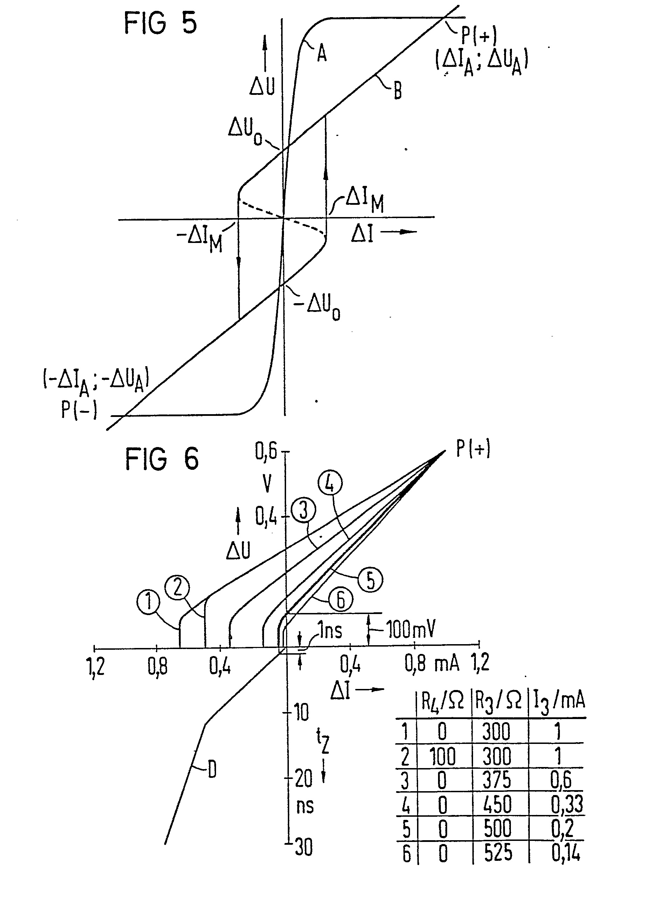

Der prinzipeille Verlauf dieser Übertragungskennlinie ist in Figur 5 durch die Kurve A dargestellt. Sie zeigt einen steilen Nulldurchgang mit einer linearen Abhängigkeit der Ausgangsgröße ΔU von ΔI und geht für größere Werte von ΔI in einen positiven bzw. negativen Sättigungsbereich über.

Für ΔI=0, d.h. $I_1 = I_2$, wird auch ΔU=0, so daß bereits sehr kleine Störungen Änderungen des Datenausgangsignals bewirken können. Dies vermeidet der erfindungsgemäße Leseverstärker nach Figur 4.

Der neue Leseverstärker besteht wieder aus einem mit dem konstanten Strom $I_3$ versorgten Differenzverstärker mit den emittergekoppelten Transistoren T5 und T6, der über Emitterfolger mit den Transistoren T7 und T8 angesteuert wird. Die die Bitleitungen abschließenden Lesewiderstände, in denen die den Leseströmen $I_1$ und $I_2$ proportionalen Spannungsabfälle zur Steuerung des Leseverstärkers entstehen, sind nunmehr in je zwei Teilwiderstände $R_3$ und $R_4$ aufgeteilt. Die Kollektoren der Transistoren T5 und T6 sind mit den gegenseitigen Verbindungspunkten C1 bzw. C2 der Teilwiderstände $R_3$ und $R_4$ verbunden und zwar überkreuz. Das bedeutet, daß der Kollektor des Transistors (z.B. T5) auf der an die Bitleitung B1 angeschlossenen Seite des Leseverstärkers an den Verbindungspunkt C2 der Teilwiderstände $R_3$ und $R_4$ an der Bitleitung B2 geführt ist und umgekehrt.

Für den Leseverstärker nach Figur 4 ergibt sich eine Übertragungskennlinie, die implizit durch die Beziehung

$$\Delta U = \{\Delta I + [1 - \frac{2}{1+e^{(\Delta U + \Delta I \cdot R_4)/U_T}}] I_3\} R_3 \qquad (1)$$

beschrieben ist. Für ΔI=0 ergeben sich drei Kennlinienpunkte: Ein labiler im negativen Widerstandsbereich bei ΔU=0 und zwei stabile bei $\Delta U = \pm U_0$. Hierbei ist $\Delta U_0$ implizit bestimmt durch:

$$\Delta U_0 = (1 - \frac{2}{1+e^{\Delta U_0/U_T}}) I_3 \cdot R_3 \qquad (2)$$

Die Übertragungskennlinie ist als Kurve B in Figur 5 dargestellt. Es zeigt sich, daß die Umkehrpunkte zwischen den beiden positiven Widerstandsbereichen und dem negativen Widerstandsbereich bei einer Stromdifferenz liegen, die im folgenden als $\Delta I_M$ und $-\Delta I_M$ bezeichnet werden. Eine Störung auf den Bitleitungen muß also mindestens den Betrag $\Delta I_M$ erreichen, wenn sie eine Störung des Datenausgangssignals bewirken soll.

Der kritische Wert der Stromdifferenz $\Delta I_M$ ergibt sich aus den vorhergehenden Gleichungen durch implizit. Differentiation zu:

3

$$\Delta I_M = \frac{U_T}{R_3 + R_4} \{ \ln[n-1+\sqrt{n(n-2)}] - n[1 - \frac{2}{n+\sqrt{n(n-2)}}]\} \qquad (3)$$

mit

$$n = \frac{I_3 \cdot R_3}{U_T} \cdot$$

Zur Einstellung der optimalen Übertragungskennlinie stehen die Widerstände $R_3$ und $R_4$ und der Strom $I_3$, der jeweils auf die Seite des größeren Lesestroms als Zusatzstrom eingespeist wird, zur Verfügung. Im allgemeinen ist ein positiver und negativer Arbeitspunkt P (+) und P (−) vorgegeben, die beispielsweise durch $\Delta I_A = 1$ mA und $\Delta U_A = 0,6$ V bzw. durch die entsprechenden negativen Werte bestimmt sind. Daneben bestehen für die Eingangs-Kippstromdifferenz $\Delta I_M$ sowie für die bei einer Eingangs-Stromdifferenz $\Delta I = 0$ bestehende Spannungsdifferenz $\Delta U_0$ hinsichtlich der Störsicherheit Mindestforderungen.

Da der Exponentialterm in den vorausgehenden Gleichungen bereits für kleine Werte von $\Delta U$ bzw. $\Delta U_0$ sehr groß wird, läßt sich die Bestimmung der drei maßgeblichen Bauelemente Werte in allen praktischen Fällen mit Hilfe der folgenden vereinfachten Gleichungen vornehmen:

$$\Delta U \approx (\Delta I + I_3) \cdot R_3,$$
$$\Delta U_0 \approx I_3 \cdot R_3$$

hieraus folgt:

$$R_3 = \frac{\Delta U_A - \Delta U_0}{\Delta I_A,}$$

$$I_3 = \frac{\Delta I_A}{\Delta U_A / \Delta U_0 - 1}$$

Der Wert für den Widerstand $R_4$ kann bei gegebener Eingangs-Kippstromdifferenz $\Delta I_M$ aus Gleichung (3) gewonnen werden.

Die Figur 6 zeigt Übertragungskennlinien ① bis ⑥, die sich aufgrund von verschiedenen Werten für $R_3$, $R_4$ und $I_3$ ergeben. Die Figur 6 enthält auch eine Tabelle, aus der die den einzelnen Übertragungskennlinien zugrundeliegenden Werte für $R_3$, $R_4$ und $I_3$ ersichtlich sind.

Die bevorzugte Übertragungskennlinie ⑤ ist in Figur 6 durch eine größere Strichdickte hervorgehoben. Für sie ergibt sich, wie aus der Darstellung abzulesen ist, $\Delta U_0 = 100$ mV und $\Delta I_M = 0,04$ mA. Die Werte für $R_3$, $R_4$ und $I_3$, können der in Figur 6 enthaltenen Tabelle entnommen werden. Es zeigt sich, daß in vielen Fällen, so auch bei der bevorzugten Kennlinie ⑤ der Wert für den Widerstand $R_4$ Null wird.

In Figur 6 ist noch eine weitere Kurve D dargestellt, welche die Abhängigkeit einer Zusatzschaltzeit $t_Z$ von der Kippstromdifferenz $\Delta I_M$ zeigt. Schaltet nämlich der Leseverstärker beim Übergang von einer auf die andere Information nicht schon bei einer Eingangsstromdifferenz $\Delta I = 0$, sondern erst nach dem Erreichen der Kippstromdifferenz $\Delta I_M$, dann benötigt er über die Grundlaufzeit $\tau$ hinaus noch die Zusatzschaltzeit $t_Z$ (vergl. Fig. 2). Neben der Kippstromdifferenz hängt diese Zeit vor allem noch von der Flankensteilheit der Leseströme ab. Der Kurve D in Figur 6 liegt eine Anstiegszeit von 35 ns und eine Abfallzeit von 70 ns zugrunde. Diese Werte können bei Speicherzellen der in Figur 1 dargestellten Art derzeit als Durchschnittswerte betrachtet werden.

**Patentansprüche**

1. Einstufiger Leseverstärker für einen Bipolar-Speicherbaustein mit matrixartig angeordneten Speicherzellen zur Auswertung der Differenz der Leseströme in einer ersten und zweiten mit je einem Lesewiderstand abgeschlossenen Bitleitung, dadurch gekennzeichnet, daß jeweils auf den die Bitleitung mit dem höheren Lesestrom abschließenden Lesewiderstand ein durch den Leseverstärker erzeugter Zusatzstrom eingespeist wird.

2. Leseverstärker nach Anspruch 1 zur Auswertung der Differenz der durch die Leseströme verursachten Spannungsabfälle an den die erste und zweite Bitleitung abschließenden Lesewiderständen, mit einem Differenzverstärker aus emittergekoppelten Transistoren (T5, T6), der mit einem konstanten Strom betrieben wird und über Emitterfolger (T7, T8) an die Bitleitungen angeschlossen ist, dadurch gekennzeichnet, daß die Lesewiderstände in je zwei Teilwiderstände ($R_3$, $R_4$) aufgeteilt sind und daß der

4

Kollektor des von der einen Bitleitung (B1) gesteuerten Transistors (T4) des Differenzverstärkers mit dem Verbindungspunkt (C2) der Teilwiderstände ($R_3$, $R_4$) der anderen Bitleitung (B2) verbunden ist und umgekehrt.

3. Leseverstärker nach Anspruch 2, dadurch gekennzeichnet, daß die zwischen den Kollektoren der Transistoren (T5, T6) des Differenzverstärkers und den Steuereingängen der Emitterfolger (T7, T8) liegenden Teilwiderstände ($R_4$) wesentlich kleiner als die jeweils anderen Teilwiderstände ($R_3$) sind.

4. Leseverstärker nach Anspruch 3, dadurch gekennzeichnet, daß die zwischen den Kollektoren de Transistoren (T5, T6) und den Steuereingängen der Emitterfolger (T7, T8) liegenden Teilwiderstände ($R_4$) verschwinden.

**Revendications**

1. Amplificateur de lecture à un étage pour un module de mémoire bipolaire comportant des cellules de mémoire disposées sous la forme d'une matrice, pour l'évaluation de la différence des courants de lecture dans une première et une seconde ligne de transmission de bits, terminées par des résistances respectives de lecture, caractérisé par le fait qu'un courant supplémentaire produit par l'amplificateur de lecture est injecté respectivement dans la résistance de lecture qui termine la ligne de transmission de bits dans lequel circule le courant de lecture le plus intense.

2. Amplificateur de lecture suivant la revendication 1 pour l'évaluation de la différence des chutes de tension, provoquées par les courants de lecture, dans les résistances de lecture terminant les première et seconde lignes de transmission de bits, comportant un amplificateur différentiel formé de transistors (T5, T6) couplés par leurs émetteurs et qui est alimenté par un courant constant et est raccordé par l'intermédiaire d'étages (T7, T8) montés en émetteurs suiveurs aux lignes de transmission de bits, caractérisé par le fait que les résistances de lecture sont subdivisées respectivement en deux résistances partielles ($R_3$, $R_4$) et que le collecteur du transistor (T5), commandé par une ligne de transmission de bits (B1), de l'amplificateur différentiel est reliée au point de jonction (T2) des résistances partielles ($R_3$, $R_4$) de l'autre ligne de transmission de bits (B2), et inversement.

3. Amplificateur de lecture suivant la revendication 2, caractérisé par le fait que les résistances partielles ($R_4$), qui sont situées entre les collecteurs des transistors (T5, T6) de l'amplificateur différentiel et les entrées de commande des éléments (T7, T8) montés en émetteurs-suiveurs, sont nettement inférieures aux autres résistances partielles respectives ($R_3$).

4. Amplificateur de lecture suivant la revendication 3, caractérisé par le fait que les résistances partielles ($R_4$), qui sont situées entre les collecteurs des transistors (T5, T6) et les entrées de commande des éléments (T7, T8) montés en émetteurs suiveurs sont supprimées.

**Claims**

1. A one-stage read-out amplifier for a bipolar storage module having storage cells in the form of a matrix, for analysing the difference between the read-out currents in a first and second bit line, each of which is terminated by a read-out resistor, characterised in that an additional current produced by the read-out amplifier can be fed to the read-out resistor which terminates the bit line with the higher read-out current.

2. A read-out amplifier as claimed in Claim 1 for analysing the difference between the drops in potential across the read resistors which terminate the first and second bit lines produced by the read-out currents, with a differential amplifier which consists of emitter-coupled transistors (T5, T6) driven by a constant current and connected to the bit lines via emitter followers (T7, T8), characterised in that the read-out resistors are each divided into two subsidiary resistors ($R_3$, $R_4$), and that the collector of that transistor (T5) of the differential amplifier controlled by the first bit line (B1) is connected to the connection point (C2) of the subsidiary resistors ($R_3$, $R_4$) of the other bit line (B2) and vice-versa.

3. A read-out amplifier as claimed in Claim 2, characterised in that the subsidiary resistors ($R_4$) located between the collectors of the transistors (T5, T6) of the differential amplifier and the control inputs of the emitter followers (T7, T8) are substantially smaller than the other subsidiary resistors ($R_3$).

4. A read-out amplifier as claimed in Claim 3, characterised in that the subsidiary resistors ($R_4$) located between the collectors of the transistors (T5, T6) and the control inputs of the emitter followers (T7, T8) are of infinitesimal value.

## FIG 1

## FIG 2

FIG 3

FIG 4

**0 047 001**

FIG 5

FIG 6

| | $R_4/\Omega$ | $R_3/\Omega$ | $I_3/mA$ |
|---|---|---|---|
| 1 | 0 | 300 | 1 |
| 2 | 100 | 300 | 1 |
| 3 | 0 | 375 | 0,6 |
| 4 | 0 | 450 | 0,33 |
| 5 | 0 | 500 | 0,2 |
| 6 | 0 | 525 | 0,14 |